# EUROPEAN PATENT APPLICATION

(11) **EP 1 598 868 A1**
(43) Date of publication of application: **23.11.2005**
(21) Application number: 04291273.3
(22) Date of filing: 18.05.2004
(51) Int. Cl.: H01L 25/065

(54) **Stacked dies having shared access to memory**

(71) Applicant: TEXAS INSTRUMENTS INC., Dallas, Texas 75265 (US); TEXAS INSTRUMENTS FRANCE, 06271 Villeneuve Loubet Cedex, Nice (FR)
(72) Inventor: Tannyeres, Louis, Vileneuve Loubet 06271 Nice (FR); Chauve, Nicolas, 06600 Antibes (FR); Leclercq, Maxime, Del mar, CA 92014 (US)
(74) Representative: Holt, Michael

(57) **Abstract**

An integrated circuit ("IC") package (10) comprises a first semiconductor die (12) and a second semiconductor die (14). The second semiconductor die (14) is coupled to the first semiconductor die (12) within the same IC package. The first semiconductor die (12) includes an interface (13) to memory (22) and the first and second semiconductor dies share said memory. The memory (22) may be located outside or inside the IC package (10) containing the first and second semiconductor dies. In another embodiment, a system comprises a first IC package containing a memory die and a second IC package coupled to the first IC package. The second IC package contains a die stack comprising first and second dies coupled together. The first die includes an interface to the memory die and both of the dies in the die stack share access to the memory die. The system may comprise a communication system such as a cellular telephone.

## Description

### FIELD OF THE INVENTION

The present subject matter relates generally to integrated circuits ("ICs"). More particularly, the present subject matter relates to an IC package comprising at least two stacked dies having shared access to a memory.

### BACKGROUND OF THE INVENTION

In many electronic systems, it is desirable for multiple devices (e.g., processors) to have access to memory for code and data storage. Determining an optimal configuration and packaging for multiple processor semiconductor dies and memory accessible to the dies is often difficult, costly, and may consume value circuit board space.

### SUMMARY OF INVENTION

In accordance with at least one embodiment of the invention, an integrated circuit ("IC") package comprises a first semiconductor die and a second semiconductor die. The first and second semiconductor dies are coupled together (e.g., "stacked") within the same IC package. The first semiconductor die includes an interface to a memory die and the first and second semiconductor dies share said memory formed on said memory die. The memory die can either be located outside or inside the IC package containing the first and second semiconductor dies.

In another embodiment, a system comprises a first IC package containing a memory die and a second IC package coupled to the first IC package. The second IC package contains a die stack comprising first and second dies coupled together. The first semiconductor die includes an interface to the memory die and both of the dies in the die stack share access to the memory die. In some embodiments, the system may comprise a communication system such as a cellular telephone or Personal Digital Assistant ("PDA").

### NOTATION AND NOMENCLATURE

Certain terms are used throughout the following description and claims to refer to particular system components. As one skilled in the art will appreciate, various companies may refer to a component by different names. This document does not intend to distinguish between components that differ in name but not function. In the following discussion and in the claims, the terms "including" and "comprising" are used in an openended fashion, and thus should be interpreted to mean "including, but not limited to." Also, the term "couple" or "couples" is intended to mean either an indirect or direct connection. Thus, if a first device couples to a second device, that connection may be through a direct connection, or through an indirect connection via other devices and connections.

### BRIEF DESCRIPTION OF THE DRAWINGS

For a more detailed description of the preferred embodiments of the present invention, reference will now be made to the accompanying drawings, wherein:

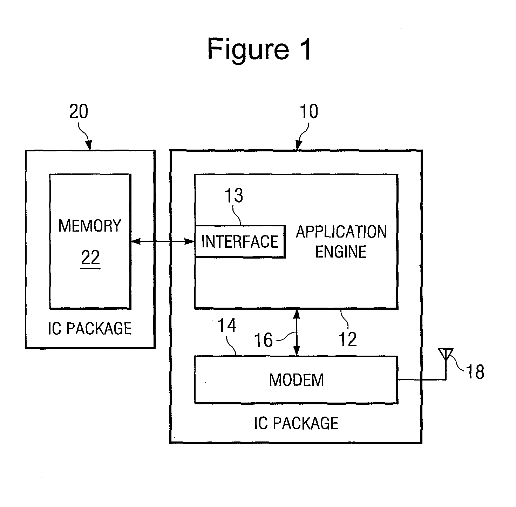

Figure 1 shows a system in accordance with a preferred embodiment of the invention that comprises a die stack having shared access to memory.

### DETAILED DESCRIPTION OF THE PREFERRED EMBODIMENTS

The following discussion is directed to various embodiments of the invention. Although one or more of these embodiments may be preferred, the embodiments disclosed should not be interpreted, or otherwise used, as limiting the scope of the disclosure, including the claims, unless otherwise specified. In addition, one skilled in the art will understand that the following description has broad application, and the discussion of any embodiment is meant only to be exemplary of that embodiment, and not intended to intimate that the scope of the disclosure is limited to that embodiment.

Figure 1 shows two IC packages 10 and 20. The IC package 10 preferably contains a plurality of semiconductor dies. In the exemplary embodiment of Figure 1, IC package 10 comprises two dies 12 and 14 coupled together as a "die stack" as will be explained below. Die 12 comprises an application engine 12 and die 14 comprises a modem engine 14. More than two dies may be included in IC package 10 if desired. The application engine 12 preferably comprises a central processing unit ("CPU") core and memory. One or more applications may be executed by the application engine 12. Examples of applications executed by the application engine comprise basic user services such as email, personal assistant and video conferencing. The modem engine 14 functions to receive and transmit information via an antenna 18 coupled to the modem. The modem engine 14 performs various modulation and demodulation functions. The IC packages 10 and 20 may form at least a part of a communication system such as a wireless device, for example, a cellular telephone. Application engine 12 and modem 14 are interconnected via an interconnect link 16.

The IC package 20 comprises preferably one semiconductor die 22, although additional dies can be included as well. The die 22 preferably comprises a memory 22 that is accessible via a memory interface 13 on the application engine 12. Both dies 12 and 14 can share access to the memory 22 via the application engine's interface 13. The memory 22 may comprise any suitable type of memory. Examples of memory comprise memory capable of single data rate or double data rate cycles, non-volatile memory (NOR, NAND Flash memory) or volatile memory such as dynamic random access memory ("DRAM") or static RAM ("SRAM"). The application engine's interface 13 is thus configured to be compatible with the type of memory implemented in IC package 20.

The dies 12 and 14 may be fabricated per the same manufacturing process or different processes. For example, die 12 may be fabricated according to a high performance complementary metal oxide semiconductor ("CMOS") process such as Texas Instruments Incorporated's 90nm CMOS technology, while die 14 may be fabricated according to a lower performance process such as Texas Instruments Incorporated's 130nm CMOS technology. The high performance CMOS process permits the application engine 12 to function at relatively high speed, albeit at the potential expense of higher leakage current than would otherwise be the case. The lower performance process used for the modem 14 may achieve lower leakage current than for the application engine 12, but modem 14 may function at a lower performance level. In general, the application engine 12 is designed for higher performance which is desirable for its functionality, whereas the modem 14 need not operate at such high performance and thus can be designed for lower leakage current to save battery (not specifically shown) life.

As noted above, the dies 12 and 14 in the IC package 20 may be coupled together to form a die stack. Any commonly known or later developed manufacturing technique for fabricating the die stack is acceptable. Exemplary die stacking techniques are provided in the following U.S. Patent. Nos.: 6,621,155; 6,674,161; and 6,682,955.

While the preferred embodiments of the present invention have been shown and described, modifications thereof can be made by one skilled in the art without departing from the scope of the claimed invention. For example, although the memory 22 is shown in Figure 1 in a separate IC package, memory 22 may included in the same IC package as the stacked dies. The embodiments described herein are exemplary only, and are not intended to be limiting. Accordingly, the scope of protection is not limited by the description set out above.

## Claims

1. An integrated circuit ("IC") package, comprising:
a first semiconductor die; and
a second semiconductor die coupled to the first semiconductor die within the same IC package;
wherein the first semiconductor die includes an interface to memory and the first and second semiconductor dies share said memory.

2. The IC package of claim 1 wherein the memory is located outside the IC package containing the first and second semiconductor dies.

3. The IC package of claim 1 wherein the memory is located inside the IC package containing the first and second semiconductor dies.

4. The IC package of any of claims 1 to 3, wherein the interface implements double data rate cycles to be run to said memory.

5. The IC package of any of claims 1 to 4, wherein the first semiconductor die is fabricated according to a different manufacturing process as the second semiconductor die.

6. The IC package of any of claims 1 to 4, wherein the first semiconductor die is fabricated according to the same manufacturing process as the second semiconductor die.

7. The IC package of any of claims 1 to 6, wherein the first semiconductor dies comprises an application engine and the second semiconductor die comprises a modem.

8. A system, comprising:
a first integrated circuit ("IC") package containing a memory die; and
a second IC package coupled to the first IC package, wherein the second IC package contains a die stack comprising first and second dies coupled together;
wherein the first die includes an interface to the memory die and both of said dies in the die stack share access to said memory die.

9. The system of claim 8 wherein the first die comprises an application engine die and the second die comprises a modem.

10. The system of claim 9 wherein the system comprises a cellular telephone.

11. The system of any of claims 8 to 10, wherein the first semiconductor die is fabricated according to a different manufacturing process than the second semiconductor die.
